# EUROPEAN PATENT SPECIFICATION

(11) **EP 1 451 830 B1**
(45) Date of publication and mention of the grant of the patent: **14.06.2006**
(21) Application number: 02798996.1
(22) Date of filing: 18.09.2002
(51) Int. Cl.: H01B 1/16

(54) **Silver conductor compositions for solar cell electrodes**
Silberleiterzusammensetzung für Solarzellelektroden
Composition conductrice à base d'argent pour électrodes de pile solaire

(30) Priority: 20.09.2001 US 323538 P
(43) Date of publication of application: 01.09.2004
(73) Proprietor: E. I. du Pont de Nemours and Company, Wilmington, Delaware 19898 (US)
(72) Inventor: KONNO, Takuya, Utsunomiya-shi, Tochigi 321-0138 (JP)
(74) Representative: Towler, Philip Dean
(86) International application number: PCT/US2002/029574
(87) International publication number: WO 2003/025954

(56) References cited:
- PATENT ABSTRACTS OF JAPAN vol. 2000, no. 15, 6 April 2001 (2001-04-06) & JP 2000 348535 A (ASAHI GLASS CO LTD), 15 December 2000 (2000-12-15)
- PATENT ABSTRACTS OF JAPAN vol. 014, no. 012 (E-871), 11 January 1990 (1990-01-11) & JP 01 258305 A (DAI ICHI KOGYO SEIYAKU CO LTD;OTHERS: 01), 16 October 1989 (1989-10-16)
- PATENT ABSTRACTS OF JAPAN vol. 014, no. 012 (E-871), 11 January 1990 (1990-01-11) & JP 01 258304 A (DAI ICHI KOGYO SEIYAKU CO LTD;OTHERS: 01), 16 October 1989 (1989-10-16)
- PATENT ABSTRACTS OF JAPAN vol. 014, no. 012 (E-871), 11 January 1990 (1990-01-11) & JP 01 258303 A (DAI ICHI KOGYO SEIYAKU CO LTD;OTHERS: 01), 16 October 1989 (1989-10-16)

## Description

### Field of the Invention

The present invention relates to solar cells and the use of a thick film conductive composition for the formation of electrodes in the production of solar cells.

### Background of the Invention

In semiconductive devices such as solar cells, when an ohmic electrode is formed on an n-type semiconductor, a thick film conductive composition is coated onto the n-type semiconductor substrate by a suitable technique such as screen printing, which is followed by electrode formation by firing in a near-infrared furnace.

A component of conductive compositions used in such applications is a glass powder added to achieve sufficient adhesive strength to the substrate during a short firing period. Typical conductive metal powders, such as silver powder, are used. The conductive metal is mixed with a glass powder (glass frit), various additives and organic medium. Typical examples for promoting the sintering effect and lowering the firing temperature in thick-film composition electrodes include electrically conductive solar cell compositions composed of a silver powder and at least one type of metal selected from vanadium, molybdenum and tungsten, or a compound thereof as described in JP-A 10-326522.

A conventional conductive composition for forming the thick-film electrodes on the n-type semiconductor substrate having a thin film for antireflection and passivation requires a glass powder as one component of the formulation, which is dissolved and breaks through the thin-film to form an electrical connection to the semiconductor upon firing. When the conductive paste composition comprises a glass composition that includes cadmium or an oxide thereof, a relatively good adhesive strength between the electrodes and substrate is achieved. A conductive paste composition comprising glass compositions without such cadmium or an oxide thereof are considered as being environmentally desirable but they cannot provide a sufficient adhesive strength between the electrodes formed therefrom. Such glass powders soften and flow during firing, and tend to segregate at the electrode/substrate boundary and on the electrode surface where they form an insulating layer that may increase the contact resistance of the electrode.

Reducing the amount of glass powder or adding or lowering the firing temperature in order to prevent segregation has the undesirable effect by markedly reducing the adhesive strength of the electrode. In cases where the aforementioned antireflection thin film is formed on the substrate surface, reducing the amount of the glass powder addition or lowering the firing temperature results in insufficient removal of such thin film causes an increase in contact resistance.

Various additives for lowering the contact resistance and enhancing adhesive strength are known. For example, conductive compositions comprising at least one metal powder selected from silver, copper and nickel, and a crystalline complex oxide comprising at least one element selected from bismuth, iron and silver and at least one Group V or Group VI element from the periodic table, which enables the formation of electrodes having a low contact resistance and a high adhesive strength are disclosed in JP-A 11-329070. Given the existence of such a trade-off between lowering the contact resistance and increasing the adhesive strength, it has not been possible to simultaneously achieve both a low contact resistance and a high adhesive strength using conductive compositions that are presently available.

It is the object of the invention to provide a thick film conductive composition for forming electrodes for use in solar cells that have a low contact resistance and also have a high adhesive strength even though the glass powders contained in the conductive composition contains no cadmium oxide.

### Summary of the Invention

The invention is directed to a solar cell comprising a solar cell electrode, wherein said electrode is obtainable by a method comprising: providing a silver conductor composition comprising silver powder, Cd-free glass powder, and particles of at least one metal oxide being selected from the group Fe₂O₃ , FeO, MnO, and Cu₂O dispersed in an organic medium, wherein said particles of metal oxide are present in an amount of 0.1 to 10.0 wt % based on total composition; coating a silicon substrate with said composition; and firing said coated substrate such that said silver powder, glass powder and metal oxides are sintered, and said organic medium is removed. The invention is also directed to the use of a silver conductor composition comprising silver powder, Cd-free glass powder, and 0.1 to 10.0 wt %, based on total composition, particles of at least one metal oxide powder being selected from the group Fe₂O₃, FeO, MnO, and Cu₂O wherein all powders are dispersed in an organic medium, in the manufacture of a solar cell.

### Detailed Description of the lnvention

The invention includes the use of a conductive composition for forming electrodes on a substrate for use in solar cells. The composition comprises silver powder, a Cd-free glass powder, and 0.1 to 10.0 wt%, based on a total weight of the composition, of metal oxide powder selected from the group Fe₂O₃, FeO, MnO, and Cu₂O in the form of finely divided solids dispersed in an organic medium. Preferably, it is the conductive composition which is characterized by using Fe oxide as the metal oxide.

It was found that the electrodes formed of the conductive paste composition have excellent adhesive strength for the electrode made therefrom and the substrate and avoids increased contact resistance of the electrode with the substrate.

When the conductive composition is used to form an ohmic electrode on an n-type semiconductor, the composition is generally prepared so that it can be formed into a thick film composition electrode by coating onto an n-type semiconductor substrate such as a silicon wafer using screen printing or other suitable processes, then firing, for example, in a near-infrared oven wherein electromagnetic radiation has relatively shorter wavelengths, for example, in the range from 0.75 to 2.5 micron. The conductive composition is used to form solar cell electrodes having low contact resistance and high bond strength. This makes it possible to provide reliable and highly durable solar cells.

### A. Conductive Metal:

Silver in the form of either flakes or a powder can be used to practice the invention. The particle size is not critical for the present invention from the standpoint of technical effects. However, the particle size does have an influence on the sintering properties of the silver powders, with larger particles resulting in a slower sintering speed than small particles. Moreover, the silver particles must be of a size suitable for the method of application to the substrate (generally screen-printing). Accordingly, the size of the silver particles should fit through the screen openings, typically not exceeding 10 microns, and preferably not exceeding 5 microns. The silver is generally of high purity (above 99%). However, silver of a lower purity may be used to satisfy the electrical requirements of the electronic conductive pattern of electrodes. The amount of silver powders in the composition is generally from 60 to 99 wt %, based on the solids (that is, excluding the liquid organic medium), and 50 to 90 wt %, based on the total weight of the composition. The conductive metal particles are substantially to totally sintered depending on the firing profile.

### B. Inorganic Binder:

In order for the composition to be fired at 580 to 800°C, and for suitable sintering, wetting and bonding to the glass substrate to take place, the inorganic binder is a cadmium-free glass frit having a softening point of 350 to 700°C.

The glass frit used in the present invention aids in sintering the silver particles to promote adhesion of the metal to the substrate upon firing and may be any well known composition, and the binder is selected according to principles well know in the art, and the chemical nature of the glass frit binder is not critical to the function of the invention. Lead silicates are widely used in the art, and may be used to work the present invention. Lead silicates and modified lead silicates such as lead borosilicate, lead aluminosilicates glasses are highly suitable from the standpoint of both the range of the softening points and the adhesion properties of the glass. Minor components of the frit other than PbO and SiO₂ may include TiO₂, B₂O₃, Bi₂O₃ and Al₂O₃.

The total amount of inorganic binder in the composition is generally 1 to 20 wt %, and preferably 1 to 10 wt %, based on the solid components of the composition.

The term "softening point," as used herein, refers to the softening point obtained by the fiber elongation method described in ASTM C338-57. The inorganic binder particles are substantially to totally sintered depending on the firing profile.

### C. Metal Oxide:

The metal oxide used in the invention is at least one selected from the group of Fe₂O₃, FeO, MnO, and Cu₂O. Iron oxide is preferred. To obtain a sufficient adhesive strength, the content of metal oxide is from 0.1 to 10 wt %, preferably 0.1 to 5.0%, and more preferably from 0.3 to 1.5%, based on total composition. Similarly, mixture of metal oxides may be used. The particle size should be of a size appropriate to the manner in which the composition of the invention is applied, which is usually by screen printing. Thus the particle size should be in about the same range as the conductive powder.

However, the addition of more than 5% of metal oxide may not give optimum sintering. Therefore, preferably not more than 5 wt %, is preferred. These oxides are important to give the composition low contact resistance and a high adhesive strength. The metal oxide particles are substantially to totally sintered depending on the firing profile.

### D. Organic Medium:

A suitable inert liquid can be used as the organic medium (vehicle). The use of an inert, non-aqueous liquid is preferred. Use may be made of any of various organic liquids that may or may not contain a thickener, stabilizer and/or other common additives. Illustrative examples of organic liquids that may be used for this purpose include alcohols or alcohol esters (e.g., acetic acid and propionate), terpenes (e.g., pine oil, terpineol), solutions of resins (e.g., polymethacrylate), solutions of ethyl cellulose in a solvent such as pine oil, and the monobutyl ether of ethylene glycol monoacetate. The medium may contain volatile liquids to promote high-speed setting after application to the substrate.

A preferred organic medium is ethyl cellulose in terpineol (1:9), in combination with a thickener blended with butyl carbitol acetate. A composition (paste) can be effectively produced on a three-roll mill. The preferred viscosity for these compositions is about 50 to 300 Pas, as measured at 10 rpm and 25°C with a Brookfield HBT viscometer using a #14 spindle and a utility cup. The amount of thickener used depends on the viscosity of the final composition; that is, on the conditions required for deposition on a substrate; for example, printing. Preferred compositions will contain, complementally, 5 to 50 wt % organic medium and 50 to 95 wt% solids. The organic medium is substantially to totally removed upon firing of the composition.

### Test Method:

(1) A conductive composition was printed and fired on the light-receiving side of a solar cell substrate so as to form a silver electrode having a film thickness of 10 µm and a size of 10 × 7 mm. Next, copper wires (width, 1 mm; thickness, 100 µm; solder-plated) were soldered on the electrode surface, thereby producing a solar cell sample. The soldering conditions were as follows: temperature, 240°C; time, 5 seconds; Pb/Sn = 60/40 paste-type solder.
(2) The adhesive strength was measured using a tensile testing machine manufactured by Instron Corp. (model 1000).

### Examples

The mode of working the invention and the features of the invention are described more fully in the following examples. In the examples, the conductive composition of the invention is described as it relates to use as an electrode-forming material on a silicon substrate.

### Comparative Examples 1 to 6:

Using the blend compositions shown in Table 1, the conductive compositions of Comparative Examples 1 to 6 were prepared in the same manner as in Example 7. The adhesive strengths of the resulting conductive compositions were measured by the method described above. The results are given in Table 2.

The specific composition of the glass is not critical, so long as Cd is absent. Preferred glasses are lead silicates, especially lead calcium aluminoborosilicates; zinc borosilicates; and lead zinc borosilicates; etc. Experimental glasses used in Comparative Examples 1 to 6 and Example 7 of Table 1 are as follows:
Cd glass (experimental product No. F2909 made by E.I. du Pont de Nemours and Company): primary glass-forming oxides include PbO, SiO₂, B₂O₃, TiO₂ and CdO and a softening point is 550°C.
Experimental Glass A (experimental product No. F2967 made by E.I. du Pont de Nemours and Company): primary glass-forming oxides include 40-70 wt% and preferably 45-60 wt% PbO, 5-25 wt% SiO₂, and 0-5 wt% Al₂O₃ and a softening point is 551°C.
Experimental Glass B (experimental product No. F2870 made by E.I. du Pont de Nemours and Company): primary glass-forming oxides include 10-20 wt% PbO, 1-10 wt% SiO₂, 1-10 wt% B₂O₃ and 65-85wt% Bi₂O₃ and a softening point is 350°C.

### Example 7:

An organic medium (terpineol containing 20 parts by weight of ethylene cellulose) was added to a mixture of 2.5 parts of Glass A, 0.5 parts of Fe₂O₃ and 75 parts of silver powder, following which the components were pre-mixed in a general-purpose mixer. The mixture was then blended on a three-roll mill, giving a conductive paste composition. The bond strength of the resulting conductive composition was measured as described above, in addition to which the diode properties were also measured. The results are presented in Table 2.

**Table 1**

| Example | | 1 | 2 | 3 | 4 | 5 | 6 | 7 |
|---|---|---|---|---|---|---|---|---|
| Cd-containing glass | wt % | Cd glass 2.5 | 0.0 | 0.0 | 0.0 | 0.0 | 0.0 | 0.0 |
| Cd-free glass | wt % | 0.0 | Glass A | Glass B | Glass A | Glass A | Glass A | Glass A |
| | | | 2.5 | 4.0 | 2.5 | 2.5 | 2.5 | 2.5 |
| Glass softening point | °C | 550 | 551 | 350 | 551 | 551 | 551 | 551 |
| Metal oxide | | none | none | none | CuO | Co₃O₄ | MgO | Fe₂O₃ |
| Amount of metal oxide added | wt % | 0 | 0 | 0 | 0.5 | 0.5 | 0.5 | 0.5 |
| Silver | wt % | 75.0 | 75.0 | 75.0 | 75.0 | 75.0 | 75.0 | 75.0 |
| Organic vehicle(Ethyl cellulose/terpineol,1/ 9) | wt % | 22.5 | 22.5 | 21.0 | 22.0 | 22.0 | 22.0 | 22.0 |

**Table 2**

| Example | | 1 | 2 | 3 | 4 | 5 | 6 | 7 |
|---|---|---|---|---|---|---|---|---|
| Adhesive strength (Max.). | N | 3.2 | 1.3 | 2.8 | 1.5 | 1.4 | 1.3 | 3.0 |
| Adhesive strength (Ave.) | N | 2.7 | 0.7 | 2.0 | 0.9 | 1.0 | 1.0 | 2.2 |
| Diode properties* | | OK | OK | NG | OK | OK | OK | OK |

| | | | | | | | | |
|---|---|---|---|---|---|---|---|---|
| *"Diode properties," as used herein, refers to a comprehensive evaluation of various parameters relating to the properties of solar cells, including the contact resistance and the acceptability of the p-n junctions. Diode properties at a level suitable for practical use were rated as "OK." | | | | | | | | |

## Claims

1. A solar cell comprising a solar cell electrode, wherein said electrode is obtainable by a method comprising:
providing a silver conductor composition comprising silver powder, Cd-free glass powder, and particles of at least one metal oxide being selected from the group Fe₂O₃, FeO, MnO, and Cu₂O dispersed in an organic medium, wherein said particles of metal oxide are present in an amount of 0.1 to 10.0 wt % based on total composition;
coating a silicon substrate with said composition; and
firing said coated substrate such that said silver powder, glass powder and metal oxides are sintered, and said organic medium is removed.

2. The solar cell according to claim 1, wherein the metal oxide is iron oxide.

3. The solar cell according to claim 1 or claim 2, wherein the particles of the metal oxide are present in an amount of about 0.1 to 5.0 wt %.

4. The solar cell according to claim 1, wherein the particles of the metal oxide are present in an amount of about 0.3 to 5.0 wt %.

5. The solar cell according to claim 1, wherein the cadmium-free glass frit comprises 45-60 wt % PbO, 5-25 wt % SiO₂, and 0-5 wt % Al₂O₃.

6. A method of making a solar cell as defined in any one of claims 1 to 5, said method comprising:
providing a silver conductor composition comprising silver powder, Cd-free glass powder, and particles of at least one metal oxide being selected from the group Fe₂O₃, FeO, MnO, and Cu₂O dispersed in an organic medium, wherein said particles of metal oxide are present in an amount of 0.1 to 10.0 wt % based on total composition;
coating a silicon substrate with said composition; and
firing said coated substrate such that said silver powder, glass powder and metal oxides are sintered, and said organic medium is removed, in order to form an electrode; and
producing a solar cell from said electrode.

7. Use of a silver conductor composition comprising silver powder, Cd-free glass powder, and particles of at least one metal oxide.being selected from the group Fe₂O₃, FeO, MnO, and Cu₂O dispersed in an organic medium, wherein said particles of metal oxide are present in an amount of 0.1 to 10.0 wt % based on total composition, in the manufacture of a solar cell.

8. Use according to claim 7 wherein said metal oxide is iron oxide.

## Patentansprüche

1. Solarzelle, die eine Solarzellenelektrode aufweist, wobei die Elektrode durch ein Verfahren mit den folgenden Schritten hergestellt werden kann:
Bereitstellen einer Silberleiterzusammensetzung, die Silberpulver, Cd-freies Glaspulver und Teilchen mindestens eines Metalloxids, das aus der Gruppe ausgewählt ist, bestehend aus Fe₂O₃, FeO, MnO und Cu₂O in einem organischen Medium dispergiert, aufweist, wobei die Metalloxidteilchen in einem Anteil von 0,1 bis 10 Gew.-% enthalten sind, bezogen auf die Gesamtzusammensetzung;
Beschichten eines Siliciumsubstrats mit der Zusammensetzung; und
Brennen des beschichteten Substrats, so daß Silberpulver, Glaspulver und Metalloxide gesintert werden und das organische Medium entfernt wird.

2. Solarzelle nach Anspruch 1, wobei das Metalloxid Eisenoxid ist.

3. Solarzelle nach Anspruch 1 oder Anspruch 2, wobei die Metalloxidteilchen in einem Anteil von etwa 0,1 bis 5,0 Gew.-% enthalten sind.

4. Solarzelle nach Anspruch 1, wobei die Metalloxidteilchen in einem Anteil von etwa 0,3 bis 5,0 Gew.-% enthalten sind.

5. Solarzelle nach Anspruch 1, wobei die cadmiumfreie Glasfritte 45-60 Gew.-% PbO, 5-25 Gew.-% SiO₂ und 0-5 Gew.-% Al₂O₃ aufweist.

6. Verfahren zur Herstellung einer Solarzelle nach einem der Ansprüche 1 bis 5, wobei das Verfahren aufweist:
Bereitstellen einer Silberleiterzusammensetzung, die Silberpulver, Cd-freies Glaspulver und Teilchen mindestens eines Metalloxids, das aus der Gruppe ausgewählt ist, bestehend aus Fe₂O₃, FeO, MnO und Cu₂O in einem organischen Medium dispergiert, aufweist, wobei die Metalloxidteilchen in einem Anteil von 0,1 bis 10 Gew.-% enthalten sind, bezogen auf die Gesamtzusammensetzung;
Beschichten eines Siliciumsubstrats mit der Zusammensetzung; und
Brennen des beschichteten Substrats, so daß Silberpulver, Glaspulver und Metalloxide gesintert werden und
das organische Medium entfernt wird, um eine Elektrode zu formen und aus der Elektrode eine Solarzelle herzustellen.

7. Verwendung einer Silberleiterzusammensetzung, die Silberpulver, Cd-freies Glaspulver und Teilchen mindestens eines Metalloxids aus der Gruppe ausgewählt, bestehend aus Fe₂O₃, FeO, MnO und Cu₂O in einem organischen Medium dispergiert, aufweist, wobei die Metalloxidteilchen in einem auf die Gesamtzusammensetzung bezogenen Anteil von 0,1 bis 10,0 Gew.-% enthalten sind, bei der Herstellung einer Solarzelle.

8. Verwendung gemäß Anspruch 7, wobei das Metalloxid Eisenoxid ist.

## Revendications

1. Cellule solaire comprenant une électrode de cellule solaire, dans laquelle ladite électrode peut être obtenue par un procédé comprenant:
la mise à disposition d'une composition conducteur d'argent comprenant de la poudre d'argent, de la poudre de verre exempte de Cd, et des particules d'au moins un oxyde métallique sélectionné parmi le groupe Fe₂O₃ , FeO, MnO et Cu₂O, dispersé dans un milieu organique, dans lequel lesdites particules d'oxyde métallique sont présentes dans une quantité de 0,1 à 10,0% en poids, sur la base de la composition totale ;
le revêtement d'un substrat en silicium à l'aide de ladite composition ; et
la cuisson dudit substrat revêtu, de telle sorte que ladite poudre d'argent, ladite poudre de verre et lesdits oxydes métalliques soient frittés et que ledit milieu organique soit éliminé.

2. Cellule solaire selon la revendication 1, dans laquelle l'oxyde métallique est oxyde de fer.

3. Cellule solaire selon la revendication 1 ou la revendication 2, dans laquelle les particules de l'oxyde métallique sont présentes dans une quantité d'environ 0,1 à 5,0% en poids.

4. Cellule solaire selon la revendication 1, dans laquelle les particules de l'oxyde métallique sont présentes dans une quantité d'environ 0,3 à 5,0% en poids.

5. Cellule solaire selon la revendication 1, dans laquelle la fritte en verre exempte de cadmium comprend 45-60% en poids de PbO, 5-25% en poids de SiO₂ et 0-5% en poids de Al₂O₃.

6. Procédé de fabrication d'une cellule solaire, telle qu'elle est définie selon l'une quelconque des revendications 1 à 5, ledit procédé comprenant :
la mise à disposition d'une composition conducteur d'argent comprenant de la poudre d'argent, de la poudre de verre exempte de Cd et des particules d'au moins un oxyde métallique sélectionné parmi le groupe Fe₂O₃ , FeO, MnO et Cu₂O dispersé dans un milieu organique, dans lequel lesdites particules d'oxyde métallique sont présentes dans une quantité de 0,1 à 10,0% en poids, sur la base de la composition totale ;
le revêtement d'un substrat en silicium à l'aide de ladite composition ; et
la cuisson dudit substrat revêtu, de telle sorte que ladite poudre d'argent, ladite poudre de verre et lesdits oxydes métalliques soient frittés et que
ledit milieu organique soit éliminé, de manière à former une électrode ; et la production d'une cellule solaire à partir de ladite électrode.

7. Utilisation d'une composition conductrice d'argent comprenant une poudre d'argent, une poudre de verre exempte de Cd, et des particules d'au moins un oxyde métallique sélectionné parmi le groupe Fe₂O₃, FeO, MnO et Cu₂O, dispersé dans un milieu organique, dans lequel lesdites particules d'oxyde métallique sont présentes dans une quantité de 0,1 à 10,0% en poids, sur la base de la composition totale, dans la fabrication d'une cellule solaire.

8. Utilisation selon la revendication 7, dans laquelle ledit oxyde métallique est oxyde de fer.
